Europäisches Patentamt

(19) European Patent Office

Office européen des brevets

(11) Publication number: **0 038 178**

**B1**

(12) **EUROPEAN PATENT SPECIFICATION**

(45) Date of publication of patent specification: **18.07.84**

(21) Application number: **81301552.6**

(22) Date of filing: **09.04.81**

(51) Int. Cl.³: **H 01 L 21/285,
H 01 L 21/268,
H 01 L 21/263**

(54) **Method of manufacturing a semiconductor device containing a Schottky barrier, and device.**

(30) Priority: **10.04.80 JP 47347/80**

(43) Date of publication of application:
**21.10.81 Bulletin 81/42**

(45) Publication of the grant of the patent:
**18.07.84 Bulletin 84/29**

(84) Designated Contracting States:
**DE FR GB NL**

(56) References cited:
**US - A - 4 059 461**

**IBM TECHNICAL DISCLOSURE BULLETIN, vol.
22, no. 11, April 1980 New York, US K.E.
PETERSEN: "Ultrathin base, beam-crystallised
bipolar transistors", pages 5053-5054**

(73) Proprietor: **FUJITSU LIMITED
1015, Kamikodanaka Nakahara-ku
Kawasaki-shi Kanagawa 211 (JP)**

(72) Inventor: **Goto, Hiroshi
No. 3-4-4, Hiyoshi Kohoku-ku
Yokohama-shi Kanagawa, 223 (JP)**
Inventor: **Sugishima, Kenji
No. 896-2-309 Kamikodanaka
Nakahara-ku Kawasaki-shi Kanagawa 211 (JP)**

(74) Representative: **Sunderland, James Harry et al,
HASELTINE LAKE & CO Hazlitt House 28
Southampton Buildings Chancery Lane
London WC2A 1AT (GB)**

Courier Press, Leamington Spa, England.

## Description

The present invention relates to a method of manufacturing a semiconductor device, more particularly a device containing a Schottky barrier diode, and a device so manufactured.

Previously, for manufacturing a bipolar semiconductor device for example, it has been common practice to form a polycrystalline or amorphous silicon layer directly under an electrode to prevent aluminium or aluminium-containing material used in the electrode from reacting with silicon and short-circuiting emitter-base and base-collector junctions, for example. The use of a Schottky barrier diode in such a bipolar semiconductor device is also known. However, there must be no polycrystalline silicon layer in a metal-semiconductor contact area for the Schottky barrier diode. In a contact area constituting a Schottky barrier, if the semiconductor is polycrystalline or amorphous, uniform contact between the metal and the semiconductor is prevented by the varied crystal grain sizes of the semiconductor, which makes it difficult to attain the properties of the Schottky barrier diode desired for its proper application with good reproducibility.

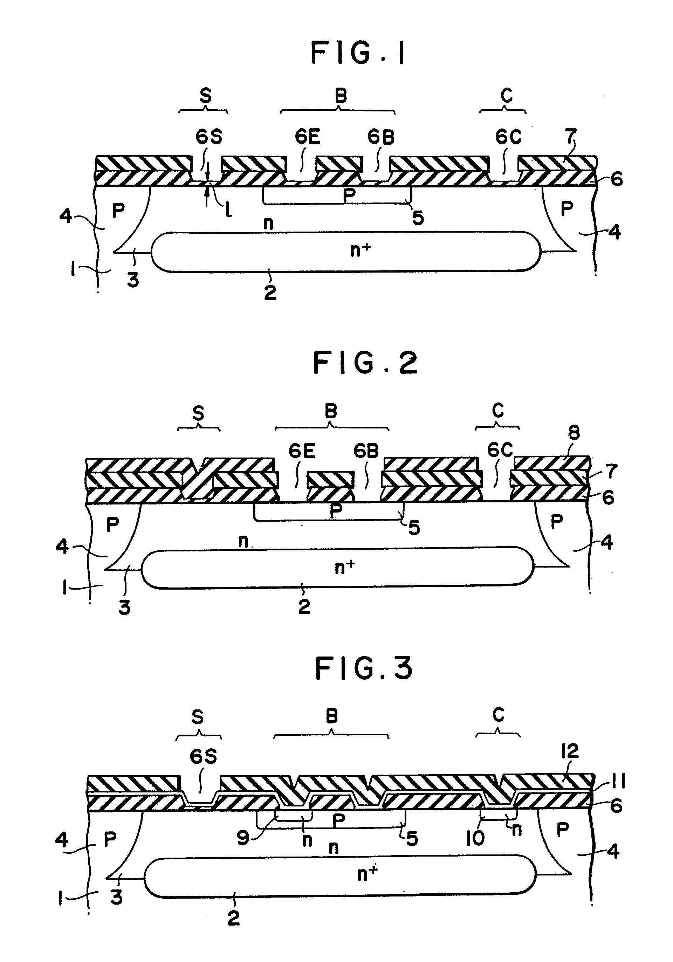

Figures 1 to 5 of the accompanying drawings are respective cross-sectional views of a part of a bipolar semiconductor device as mentioned above at respective successive stages in its manufacture. An explanation of a typical conventional method of manufacturing such a device will now be described with reference to Figures 1 to 5.

Referring to Figure 1:

(1) on a silicon semiconductor substrate 1, an $n^+$-type buried layer 2 is formed, followed by epitaxial growth of an n-type silicon semiconductor layer 3, in which are formed p-type isolation regions 4 contacting the substrate 1, and a p-type base region 5. The surface of the epitaxial layer is covered with a field oxide layer 6. B, S and C are regions in which a base, a Schottky barrier diode and a collector contact are to be formed, respectively.

(2) the field oxide layer 6 is patterned by ordinary photolithography to provide windows 6S, 6E, 6B and 6C in which a Schottky barrier diode, an emitter, a base contact and a collector contact are to be formed, respectively. The etching process is continued until the field oxide layer 6 is only approximately 1000 Å thick, as indicated by reference character 1. 7 is a photoresist layer used as a mask in this process.

Referring to Figure 2:

(3) a second photoresist layer 8 is formed which has a pattern for exposing the bottoms of the windows 6E, 6B and 6C in which an emitter, a base contact and a collector contact are to be formed, respectively.

(4) the field oxide layer 6 is etched, with the second photoresist layer 8 serving as a mask, to expose the bottoms of the windows 6E, 6B and 6C in which an emitter, a base contact and a collector contact are to be formed, respectively.

Referring to Figure 3:

(5) the photoresist layers 7 and 8 are all removed.

(6) a polycrystalline silicon layer 11 approximately 800 Å thick is formed by a chemical vapour growth method in which monosilane $SiH_4$ is decomposed.

(7) a new mask of photoresist film is formed, which is utilized in a process for introducing an impurity of conductivity type opposite to that of the base region to form an emitter region 9 and a collector contact region 10.

(8) a photoresist layer 12 is formed which has an opening for exposing the top surface of the field oxide layer 6 in the window 6S in which a Schottky barrier diode is to be formed.

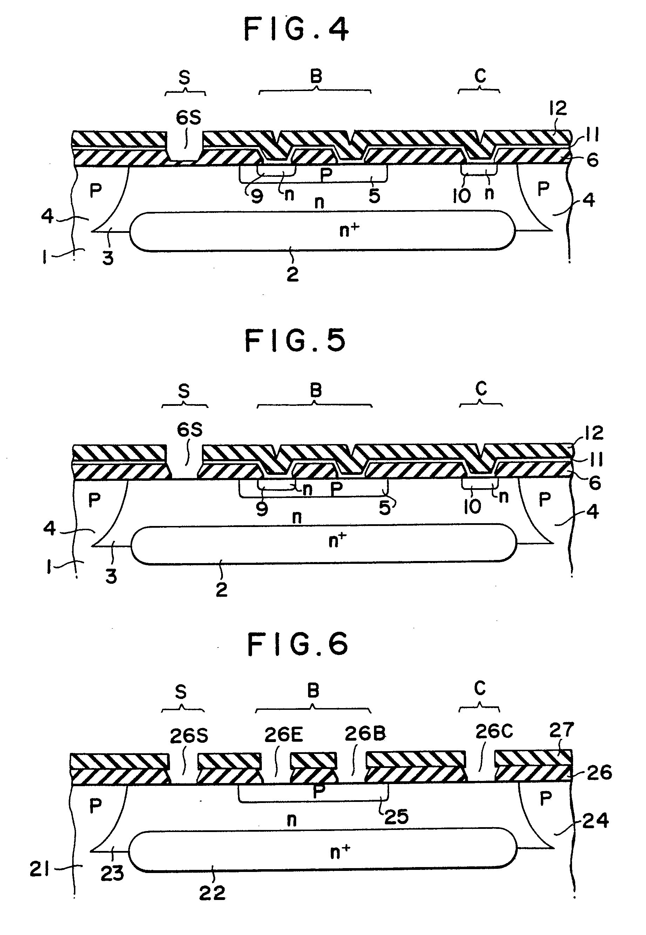

Referring to Figure 4:

(9) the polycrystalline silicon layer 11 is patterned, with the photoresist layer 12 serving as a mask, to expose the top surface of the field oxide layer 6 in the window 6S.

Referring to Figure 5:

(10) the field oxide layer 6 is etched to complete the window 6S in which a Schottky barrier diode is to be formed. In etching the field oxide layer 6, a new photoresist layer, if necessary, is to be formed.

(11) the photoresist layer 12 is removed, and a first aluminium layer electrode is attached. Wiring and some other required processes complete the semiconductor device product.

Thus, conventionally, attachment of polycrystalline silicon to the substrate surface where a Schottky barrier diode is to be formed can be avoided only by the use of two photoresist layers. The photoresist material must be of negative type.

Generally, positive type photoresist is more suitable than negative type for attaining microfabrication, but if positive type is applied in two layers, the first layer is melted when the second layer is coated thereupon. Thus, positive photoresist cannot be used in a conventional procedure as described above.

US—A—4 059 461 discloses means for improving the crystallinity of an amorphous silicon layer, deposited as by sputtering on a substrate, by irradiation with a laser beam, to provide an improved photovoltaic cell. A rectifying contact with the irradiated layer may be provided by depositing a highly conducting tin doped indium oxide film over a thin transparent metallic layer to form a Schottky barrier.

IBM Technical Disclosure Bulletin, Volume 22, No. 11, April 1980, pages 5053—5054, in an article entitled "Ultra-thin base beam-crystallised bipolar transistors", discloses the use of a laser or electron beam to crystallise polysilicon base and emitter regions.

According to the present invention there is provided a method of manufacturing a semiconductor device containing a Schottky barrier, comprising

forming an insulating layer on a semiconductor substrate,

forming a window in the insulating layer, in which the substrate is exposed, for an electrode of the device,

forming a polycrystalline or amorphous semiconductor layer in the window and on the insulating layer, for separating electrode material from the substrate in the window,

depositing electrode material on the semiconductor layer in the window to establish ohmic contact between the electrode material and the semiconductor layer,

and also forming the Schottky barrier, characterised by

forming a further window in the insulating layer, in which the substrate is exposed, for the Schottky barrier, forming the semiconductor layer also in the further window,

irradiating the semiconductor layer in the further window with an energy beam to convert the semiconductor layer into a monocrystalline semiconductor layer in the further window, and

depositing a metal or metal-containing material on the monocrystalline semiconductor layer in the further window for a Schottky contact between that material and the monocrystalline semiconductor layer.

An embodiment of the present invention can provide an easy and simple method of manufacturing a bipolar semiconductor device containing a Schottky barrier diode in a process which in some respects is substantially the same as a conventional process for manufacturing bipolar semiconductor devices, but without the need to use two layers of photoresist material, without leaving part of an insulating layer such as silicon dioxide film in a window in which a Schottky barrier diode is to be formed and hence without the need of a two-step process, such as has been conventionally required, to complete the window.

Reference is made, by way of example, to the accompanying drawings, in which:—

Figures 1 to 5 are respective cross-sectional views of a part of a semiconductor device at respective successive stages of its manufacture in accordance with a conventional manufacturing method; and

Figures 6 to 10 are respective cross-sectional views of a part of a semiconductor device at respective stages of its manufacture in accordance with an embodiment of the present invention.

Referring to Figure 6:

(1) on a silicon semiconductor substrate 21 an $n^+$-type buried layer 22 is formed, followed by epitaxial growth of an n-type silicon semiconductor layer 23, on which are formed p-type isolation regions 24 contacting the substrate 21, and a p-type base region 25 and the surface is covered with a field oxide layer 26, having a thickness of 4000 Å to 8000 Å, by a thermal oxidation method.

(2) the field oxide layer 26 is patterned by ordinary photolithography, with a photoresist layer 27 used as a mask, to provide complete windows 26S, 26E, 26B and 26C in which a Schottky barrier diode, an emitter, a base contact and a collector contact are to be formed, respectively. The photoresist layer 27 used can be of any type, for example positive type.

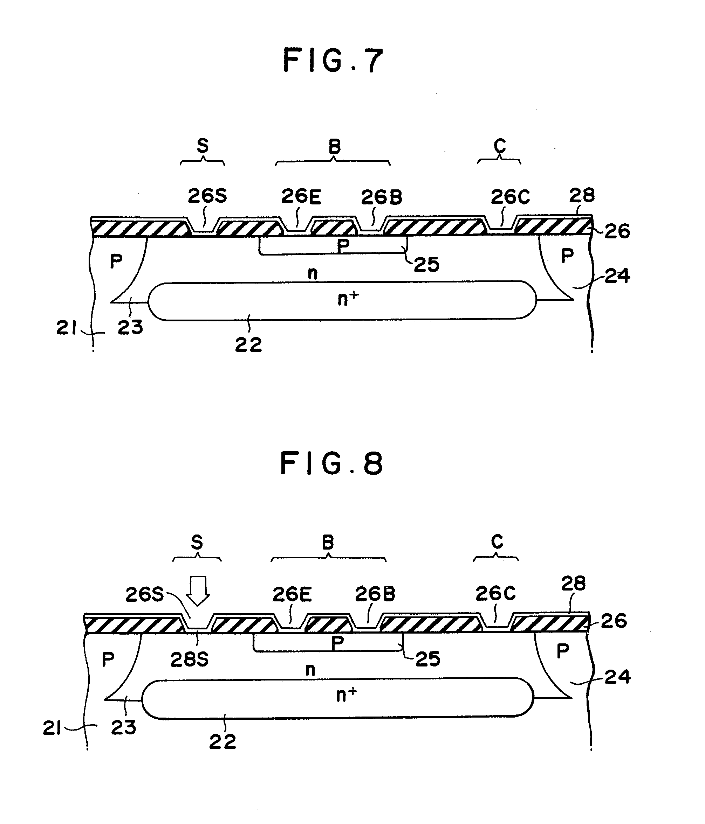

Referring to Figure 7:

(3) after removal of the photoresist layer 27, a silicon layer 28 having a thickness of approximately 1000 Å is formed by a chemical vapour growth method. The silicon layer 28 formed is polycrystalline or amorphous.

Referring to Figure 8:

(4) a portion of the silicon layer 28 corresponding to the window 26S in which a Schottky barrier diode is to be formed is irradiated by an energy beam such as a laser beam. The heated and melted silicon is recrystallised in a monocrystalline state. In this process, the top surface of the epitaxial layer 23 serves as a nucleus for the growth of the melted silicon and the silicon layer 28 undergoes monocrystallisation starting from a portion thereof contacting the epitaxial layer 23 within the window 26S up to a portion thereof on the field oxide layer 26. In Figure 8, the monocrystallized portion is shown by reference numeral 28S.

If desired, it is a matter of course that the whole silicon layer 28 can be monocrystallized.

If a Q-switch laser beam is used in heating the silicon layer, the irradiation thereby should be effected once or more with a pulse width adjusted to a few scores of nanoseconds. If a CW-oscillated argon laser is used, the laser spot should be scanned to provide 10J to 60J of heat per cm² of irradiated area. Silicon layer 28 having a thickness of 1000 Å melts at 20 to 30 J/cm².

Alternative energy beams that may be used are a thermal radiation beam, an electron beam and an ion beam.

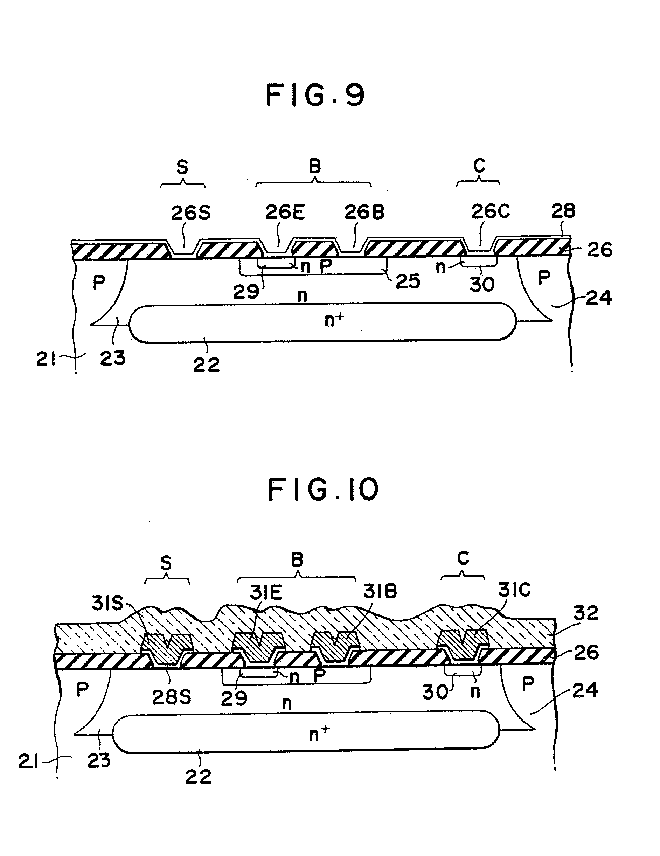

Referring to Figure 9:

(5) a phosphosilicate glass layer (not shown) approximately 5000 Å thick is formed, as a source of diffusion impurity, by a chemical vapour growth method. The phosphosilicate glass layer is then patterned by ordinary photolithography to leave only those parts of this layer in the windows 26E and 26C in which an emitter and a collector contact are to be formed, respectively, the rest of the surface being left devoid of phosphosilicate glass material.

(6) an n-type emitter region 29 and an n-type collector contact region 30 are formed, using phosphorus from the phosphosilicate glass layer diffused through the silicon layer 28 into the semiconductor layer 23, by a 800°C heat treatment carried out for about 2 minutes in a nitrogen ($N_2$) atmosphere.

(7) the phosphosilicate glass layer is removed by hydrofluoric acid (HF) etching.

Referring to Figure 10:

(8) an aluminium (Al) layer having a thickness of 7000 Å to 10,000 Å is formed by a sputtering method, and the aluminium layer is then patterned by photolithography. Using the so-formed aluminium electrode as a mask, the silicon layer 28 is selectively etched to form a Schottky barrier diode electrode 31S, an emitter electrode 31E, a base electrode 31B and a collector electrode 31C.

(9) a covering phosphosilicate glass layer 32 is formed by a chemical vapour growth method. This completes the manufacture of the desired semiconductor device.

Above, a process for forming the emitter region 29 and the collector contact region 30 involving solid-solid diffusion has been described, but in other embodiments of this invention those regions may alternatively be formed by other methods including ion implantation. The formation of regions 29 and 30 may be carried out before the silicon layer 28 is formed.

By forming an electrode, such as an aluminium electrode as mentioned above, on the monocrystallized silicon layer as described, the same Schottky barrier is attained as that provided by forming an aluminium electrode on ordinary monocrystalline silicon.

As will be understood from the foregoing, an embodiment of the present invention provides a method of manufacturing a semiconductor device containing a Schottky barrier diode and a silicon layer which prevents reaction of silicon with aluminium, wherein no polycrystalline or amorphous silicon layer exists in the region in which the Schottky barrier diode is formed, wherein the use of two layers of photoresist mask material is not required, and wherein the etching of a polycrystalline or amorphous silicon dioxide layer, as conventionally required, is avoided.

In embodiments of this invention any photoresist material can be used, including positive type photoresist, which is more suitable for microfabrication than negative type.

Accordingly, a semiconductor device containing a Schottky barrier diode with an improved degree of circuit integration can be manufactured by a very simple process in a method embodying this invention as described above.

Generally, a complicated process has been required in the manufacture of a semiconductor device containing a Schottky barrier diode and a polycrystalline silicon layer for preventing excessive reaction of an aluminium electrode with silicon material involved, because, owing to the inability of an aluminium electrode to provide a good Schottky barrier by contact with a polycrystalline silicon layer the aluminium electrode for Schottky barrier formation has been required to contact directly a monocrystalline silicon semiconductor layer or substrate. An embodiment of the present invention, provides for simplification of the process required by monocrystallizing the polycrystalline silicon layer at least in the region in which a Schottky barrier diode is to be formed by annealing the silicon layer in that region by laser beam irradiation, for example, and applying an aluminium electrode thereto.

## Claims

1. A method of manufacturing a semiconductor device containing a Schottky barrier, comprising

forming an insulating layer on a semiconductor substrate,

forming a window in the insulating layer, in which the substrate is exposed, for an electrode of the device,

forming a polycrystalline or amorphous semiconductor layer in the window and on the insulating layer, for separating electrode material from the substrate in the window,

depositing electrode material on the semiconductor layer in the window to establish ohmic contact between electrode material and the semiconductor layer,

and also forming the Schottky barrier, characterised by

forming a further window in the insulating layer, in which the substrate is exposed, for the Schottky barrier.

forming the semiconductor layer also in the further window,

irradiating the semiconductor layer in the further window with an energy beam to convert the semiconductor layer into a monocrystalline semiconductor layer in the further window, and

depositing a metal or metal-containing material on the monocrystalline semiconductor layer in the further window for a Schottky contact between that material and the monocrystalline semiconductor layer.

2. A method as claimed in claim 1, comprising

forming windows in the insulating layer, in which the substrate is exposed, for each of an emitter electrode, a base contact electrode and a collector contact electrode,

forming the polycrystalline or amorphous semiconductor layer in each of those windows, and

depositing electrode material on the semiconductor layer in each of those windows.

3. A method as claimed in claim 1 or 2, wherein the semi-conductor layer is of silicon.

4. A method as claimed in claim 1, 2 or 3, wherein the energy beam is a photon beam, or an electron beam or an ion beam.

5. A method as claimed in claim 4, wherein the energy beam is a laser beam.

6. A semiconductor device made by a method as claimed in any preceding claim.

## Patentansprüche

1. Verfahren zur Herstellung einer Halbleitervorrichtung mit Schottky-Sperrschicht, bei dem

eine isolierende Schicht auf einem Halbleitersubstrat gegebildet wird,

ein Fenster in der isolierenden Schicht gebildet wird, in dem das Substrat für eine Elektrode der Vorrichtung freigelegt wird,

eine polykristalline oder amorphe Halbleiterschicht in dem Fenster und auf der isolierenden Schicht zum Trennen des Elektrodenmaterials von dem Substrat in dem Fenster Gebildet wird,

ein Elektrodenmaterial auf der Halbleiterschicht in dem Fenster niedergeschlagen wird, um einen ohmschen Kontakt zwischen dem Elektrodenmaterial und der Halbleiterschicht herzustellen, und

die Schottky-Sperrschicht gebildet wird, dadurch gekennzeichnet, daß

ein weiteres Fenster in der isolierenden Schicht gebildet wird, in dem das Substrat für die Schottky-Sperrschicht freigelegt wird,

die Halbleiterschicht auch in dem weiteren Fenster gebildet wird,

die Halbleiterschicht in dem weiteren Fenster mit einem Energiestrahl bestrahlt wird, um die Halbleiterschicht in eine monokristalline Halbleiterschicht in dem weiteren Fenster umzuwandeln, und

ein Metall oder ein Metall enthaltendes Material auf der monokristallinen Halbleiterschicht in dem weiteren Fenster für einen Schottky-Kontakt zwischen dem Material und der monokristallinen Halbleiterschicht niedergeschlagen wird.

2. Verfahren nach Anspruch 1, bei dem

Fensten in der isolierenden Schicht, in denen das Substrat freigelegt wird, für jeweils eine Emitterelektrode, eine Basiskontaktelektrode und eine Kollektorkontaktelektrode gebildet werden,

die Polykristalline oder amorphe Halbleiterschicht in jedem dieser Fenster gebildet wird und

ein Elektrodenmaterial auf der Halbleiterschicht in jedem dieser Fenster niedergeschlagen wird.

3. Verrahren nach Anspruch 1 oder 2, bei dem die Halbleiterschicht aus Silizium besteht.

4. Verfahren nach Anspruch 1, 2 oder 3, bei dem der Energiestrahl ein Photonenstrahl oder ein Elektrodenstrahl oder ein Ionenstrahl ist.

5. Verfahren nach Anspruch 4, bei dem der Energiestrahl ein Laserstrahl ist.

6. Halbleitervorrichtung, hergestellt durch das Verfahren nach einem der vorangehenden Ansprüche.

## Revendications

1. Un procédé de fabrication d'un dispositif semiconducteur contenant une barrière de Schottky, dans lequel

on forme une couche isolante sur un substrat semiconducteur,

on forme dans la couche isolante une fenêtre dans laquelle le substrat est à nu, pour une électrode du dispositif,

on forme une couche de semiconducteur polycristallin ou amorphe dans la fenêtre et sur la couche isolante, pour séparer la matière de l'électrode par rapport au substrat, dans la fenêtre,

on dépose de la matière d'électrode sur la couche de semiconducteur dans la fenêtre, pour établir un contact ohmique entre la matière d'électrode et la couche de semiconducteur,

et on forme également la barrière de Schottky, caractérisé en ce que:

on forme dans la couche isolante une fenêtre supplémentaire, dans laquelle le substrat est à nu, pour la barrière de Schottky,

on forme également la couche de semiconducteur dans la fenêtre supplémentaire,

on irradie la couche de semiconducteur dans la fenêtre supplémentaire avec un faisceau énergétique pour convertir la couche de semiconducteur en une couche de semiconducteur monocristallin dans la fenêtre supplémentaire, et

on dépose un métal ou une matière contenant un métal sur la couche de semiconducteur monocristallin dans la fenêtre supplémentaire, pour former un contact de Schottky entre cette matière et la couche de semiconducteur monocristallin.

2. Un procédé selon la revendication 1, dans lequel

on forme dans la couche isolante des fenêtres, dans lesquelles le substrat est à nu, pour chaque élément comprenant une électrode d'émetteur, une électrode de contact de base et une électrode de contact de collecteur,

on forme dans chacune de ces fenêtres la couche de semiconducteur polycristallin ou amorphe, et

on dépose la matière d'électrode sur la couche de semiconducteur dans chacune des ces fenêtres.

3. Un procédé selon la revendication 1 ou 2, dans lequel la couche de semiconducteur est en silicium.

4. Un procédé selon la revendication 1, 2 ou 3, dans lequel le faisceau énergétique est un faisceau de photons ou un faisceau d'électrons ou un faisceau d'ions.

5. Un procédé selon la revendication 4, dans lequel le faisceau énergétique est un faisceau laser.

6. Un dispositif semiconducteur fabriqué par un procédé selon l'une quelconque des revendications précédentes.

# FIG. 1

# FIG. 2

# FIG. 3

# FIG.4

# FIG.5

# FIG.6

# FIG.7

# FIG.8

# FIG.9

# FIG.10